Europäisches Patentamt

European Patent Office

Office européen des brevets

(11) Publication number: **0 427 364 A2**

# EUROPEAN PATENT APPLICATION

(21) Application number: 90300472.9

(22) Date of filing: 17.01.90

(51) Int. Cl.5: **H03M 11/00**

(30) Priority: 06.11.89 US 431934

(43) Date of publication of application:
15.05.91 Bulletin 91/20

(84) Designated Contracting States:
DE FR GB

(71) Applicant: **ACER INCORPORATED**
**No. 1, Industry E. Road 3, Hsinchu**
**Science-Based Industrial Park**
**Hsinchu 300(TW)**

(72) Inventor: **Wu, Dennis Tse-Shuan**
**265, Yun-An Road Mei Lung Town**
**Kao-Hsiung Hsien Taiwan(TW)**

(74) Representative: **Skone James, Robert Edmund**
**et al**
**GILL JENNINGS & EVERY 53-64 Chancery**
**Lane**
**London WC2A 1HN(GB)**

(54) **An encoding circuit for a keyboard.**

(57) A ladder-type encoding circuit is described for
use with a keyboard interface, especially for use with
the input/output pins of a single chip keyboard inter-
face (111). The circuit is connected to the
input/output pins by lines (1-21) used both for scan-
ning and for sensing. The lines are arranged so that
they run in a generally parallel direction and they
then cross over the other lines so that the crossover
points may be connected electrically by the de-
pressing of keys. During scanning, one of the lines is
set to a particular logic state with the remaining lines
at a different logic state and the remaining lines
sensed to detect the depressing of keys correspond-
ing to crossover points between the lines scanned
and the line set to a particular logic state. The
ladder-type encoding circuit fully utilizes the capabil-
ity of the input/output pins of the interface chip and
reduces the number of pins required for sensing the
depression of keys.

Fig. 4.

# AN ENCODING CIRCUIT FOR A KEYBOARD

This invention relates in general to information input systems such as keyboards and in particular to an encoding circuit for the keyboard.

In conventional keyboard designs, a single chip integrated circuit (IC) with forty pins is used to control the different electronic components in a keyboard interface circuit, such as signal generators and the input/output of signals. The keyboard interface circuits presently used employ matrix-type encoding circuits for scanning and sensing the depressing of keys of the keyboard. In the matrix-type encoding circuits, the scan lines and sense lines form an X-Y matrix where the scan lines run in the X direction and the sense lines run in the Y direction, or vice versa. In the commonly used 101/102-type keys, where eight sense lines and thirteen scan lines are used, for sensing 104 keys, the matrix-type encoding circuit requires or uses up twenty-one input/output pins of the IC chip for controlling the keyboard interface. Since the IC control chip for the keyboard has a limited number of input/output pins, it is desirable to provide an improved encoding circuit that is more efficient in the use of input/output pins.

In accordance with one aspect of the present invention, an encoding circuit for a keyboard, the keyboard having keys for input of information when they are depressed comprises n lines used for both scanning sand sensing the depressing of keys, n being a positive integer, wherein the lines are arranged with respect to one another and the keys of the keyboard so that any line is electrically connectable to any of the remaining lines by depressing appropriate keys.

In accordance with a second aspect of the invention a method of operating a circuit according to the first aspect of the invention wherein the lines are arranged with respect to one another and the keys of the keyboard so that the mth line is electrically connectable to any of the remaining lines by depressing appropriate keys comprises applying a voltage to the mth line so that it is at a predetermined logic high or low state; applying voltages to the remaining lines so that they are at a logic state that it is different from that of the mth line; and sensing the logic states of the remaining lines to detect whether any of the keys has been depressed.

This invention is based on the observation that since the pins used for detecting the depressing of keys are input/output pins, the lines connected to these pins for detecting the depressing of keys need not be rigidly separated into scanning and sensing lines. Instead they can be used for both purposes and the input/output pins may be used for both scanning and sensing purposes. This optimizes the use of the input/output pins.

This invention is directed towards an encoding circuit for a keyboard where the keyboard has keys for input of information when they are depressed. The circuit comprises n lines used both for scanning and sensing the depressing of keys, where n is a positive integer. The lines are arranged with respect to one another and the keys of the keyboard so that each line is electrically connectable to any of the remaining lines by the depressing of keys.

The n lines can be used to sense the depressing of $n(n-1)/2$ keys. In the preferred embodiment, the lines are arranged in a predetermined order from the first line to the nth line.

Some examples of circuits according to the invention will now be described and contrasted with known circuits with reference to the accompanying drawings, in which:-

Fig. 1 is a schematic view of Intel single chip integrated circuit 8049/8035, showing the pins available on such a chip;

Figure 2 is a schematic circuit diagram of the IC chip of Fig. 1 and a matrix-type encoding circuit used in conventional systems;

Fig. 3 is a schematic circuit diagram of the IC chip of Fig. 1 and another conventional matrix-type encoding circuit;

Fig. 4 is a schematic view of the IC chip of Fig. 1 and an encoding circuit connected to twenty-one pins of the chip to illustrate the invention;

Fig. 5 is a schematic view of the IC chip of Fig.1 and an encoding circuit connected to fifteen pins of the chip to illustrate the invention;

Fig.6 is a timing diagram illustrating the timing between the signals on the scan lines and the time interval for detecting data from the sense lines; and,

Figs. 7-9 are schematic views of the IC chip of Fig. 1 and an encoding circuit connected to four pins of the chip to illustrate the invention.

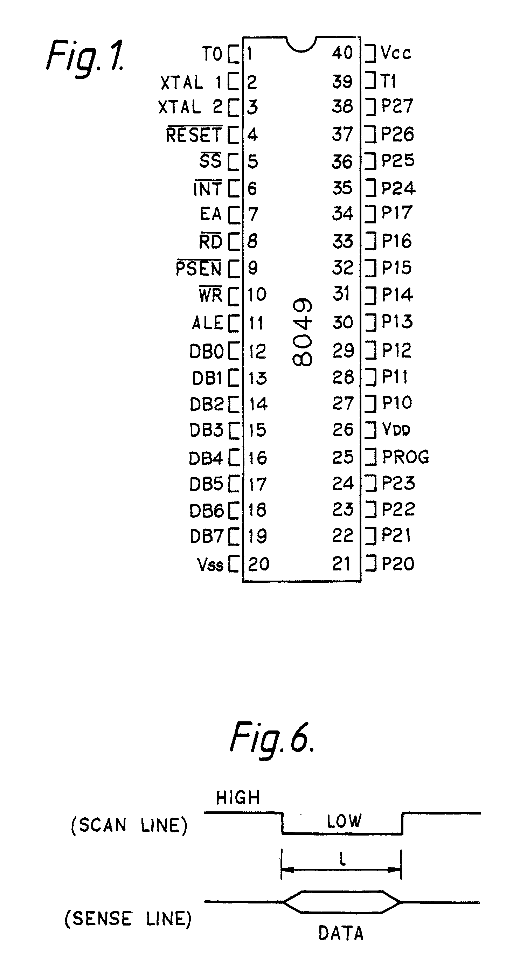

Fig. 1 is a schematic circuit diagram of the Intel IC chip 8049/8035 for controlling keyboard interfaces. The 8049 chip has twenty-seven input/output pins where pin numbers 1, 6, 29 can be used only as input pins and where pin numbers 27-34, 21-24, 35-38 and 12-19 are input/output pins. Out of the twenty-seven input/output pins, the conventional matrix-type encoding circuit requires and uses up twenty-one, leaving only sixty input/output pins for other purposes. The detailed description of the functions of each pin is found in specifications published by Intel.

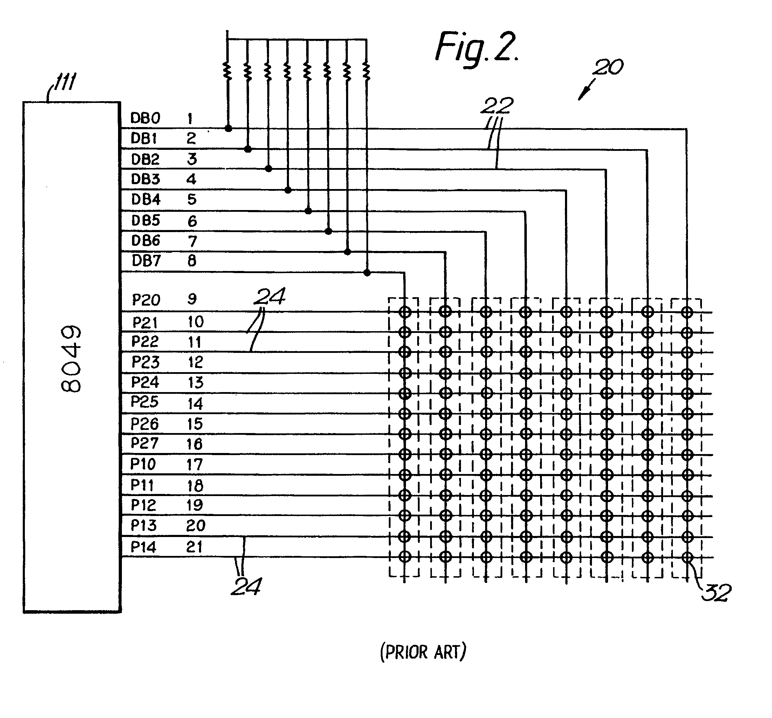

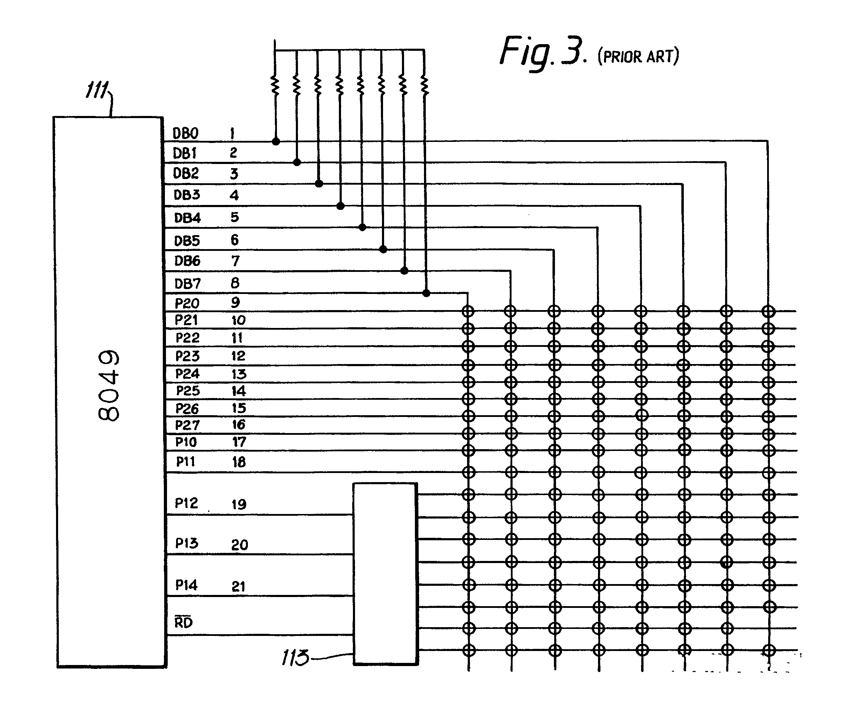

Fig. 2 is a schematic circuit diagram of the 8049 chip 111 and a conventional matrix-type decoding circuit 20. As shown in Fig. 2, circuit 20 includes eight sense lines 22 and thirteen scan lines 24. The eight sense lines cross over the thirteen scan lines to form a matrix of one hundred and four points each corresponding to a key (shown as a circle at the crossover point) as shown in Fig. 2. The depressing of each of one hundred and four (8X13) keys may be detected using the eight sense lines and the thirteen scan lines. As shown in Fig. 2, the one hundred and four keys are arranged in eight arrays, each array with thirteen keys. Each key is located relative to a crossover point between the sense and scan lines so that depressing the key will cause one and only one sense line to be electrically connected to one and only one scan line. Thus, depressing the key 32, will cause the sense line connected to pin DBO of chip 111 and the scan line connected to pin P14 of the chip to be electrically connected. If the scan line connected to pin P14 is in the logic high state and the sense line connected to pin DBO is at logic low, the logic low and high states for the circuit 20 are set so that depressing the key 32 will cause the sense line connected to pin DBO to be pulled high, which is accomplished in a conventional manner. In this manner, whether key 32 has been depressed can be detected.

In a process known as scanning, voltages are applied during certain clock cycle(s) to the scan lines so that one of the thirteen scan lines is in the logic high state with the remaining scan lines maintained at logic low state, and voltages are applied to the scan lines during subsequent clock cycles so that this pattern is periodically changed over time with a different scan line being maintained at logic high state with the remaining lines at logic low. Whether any of the one hundred and four keys has been depressed can be detected by sensing the voltage levels of the eight sense lines during the time period required for scanning all thirteen scan lines 24.

According to the scheme of Fig. 2, in order to detect the depressing of one or more keys, twenty-one input/output pins are used, each pin connected to a scan line or a sense line. Therefore, few input/output pins are left for other purposes.

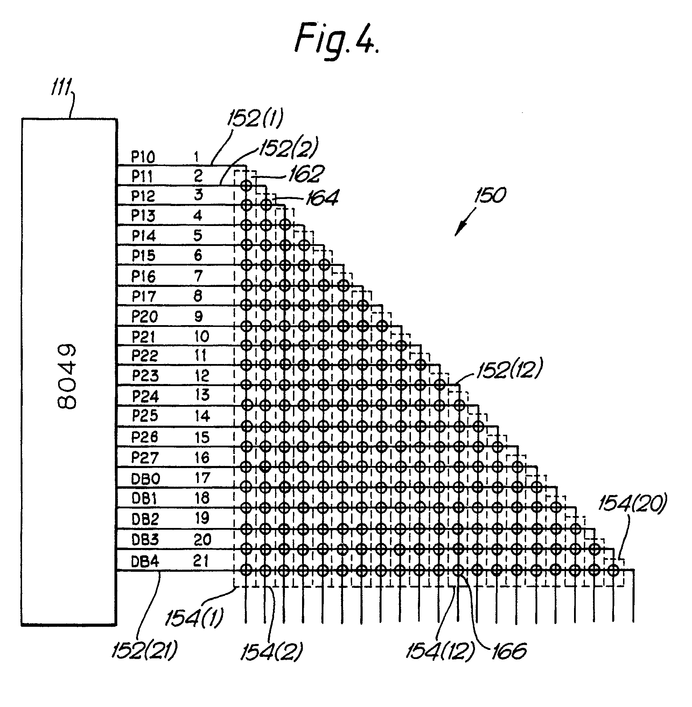

Fig. 3 is a schematic circuit diagram of the IC chip 8049 together with another conventional encoding scircuit. To reduce the number of input/output pins required while still retaining the capability to detect a large number of keys, one conventional design technique is to employ a decoder as shown in Fig. 3. As shown in Fig. 3, decoder 113 enables eight scan lines to be controlled through four input/output pins, thereby saving four input/output pins for other purposes. The inclusion of an additional decoder increases the cost and complexity of the encoding circuit and is therefore undesirable.

Yet another approach is to replace IC 8049 with the more advanced IC chip 8051 with forty pins out of which thirty-two are input/output pins. However, such more advanced chip is more expensive than the design of Fig. 3 (the 8049 chip plus the decoder). For this reason this approach is seldom adopted.

From the above it is evident that when the matrix-type conventional encoding circuit is used, the limited number of input/output pins on the control chip limits the number of keys which may be sensed. If the sensing of more keys is desired, a decoder must be added or a more expensive control chip must be used. Even when the more advanced chip IC 8051 is used, its input/output pins are limited to only thirty-two so that the use of the more advanced chip does not significantly increase design flexibility. This invention alleviates the above described difficulties.

Fig. 4 is a schematic view of 8049 chip 111 and encoding circuit 150 to illustrate the preferred embodiment of the invention. As shown in Fig. 4, circuit 150 includes twenty-one lines 152 used for both scanning and for sensing where the twenty-one lines are labelled 152(1), 152(2), ... 152(21). The keys to be sensed by the twenty-one lines are arranged in twenty arrays, each array corresponding to one of the lines except for one of the twenty-one lines. As shown in Fig. 4, array 154(1) corresponds to the line 152(1), and the array 154(2) corresponds to the line 152(2) and so on until the array 152(20) corresponds to the line 152(20). Line 152(21) has no array corresponding to it.

The twenty-one lines and the twenty arrays are arranged in a ladder-type configuration. The twenty-one lines all proceed in the same general direction and then bend downwards to cross over at least some of the other twenty lines; however, line 152(21) does not cross over any of the other lines after bending. Thus line 152(1) crosses the remaining twenty lines at twenty points. Array 154-(1) has twenty keys, each corresponding to a crossover point between line 152(1) and one of the remaining twenty lines. The keys are so connected to the twenty-one lanes so that the depressing of one key will cause the two lines which cross over at a cross over point corresponding to such key to be electrically connected by a conventional means, such as a switch. Thus the depressing of key 162 in array 154(1) will cause line 152(1) to be electrically connected to line 152(2). The depressing of key 164 in array 154(2) will cause line 152(2) to be connected electrically to line 152(3). Therefore, the depressing of keys 162, 164 may be detected through lines 21 in a manner described below. In a similar manner, whether any of the keys in all twenty arrays has been depressed can be detected.

In order to detect whether any of the keys in the twenty arrays is depressed, the following scanning and sensing procedure may be used: Voltages are applied to all twenty-one lines so that line 152-(21) is in the low logic state while the remaining twenty lines are at the high logic state. The logic states are such that if any of the twenty lines is electrically connected to line 152(21), such line would be pulled low, such as by being connected to ground. Lines 152(1) through 152(20) are then sensed. If these twenty lines remain at the high logic state, that means no key has been depressed. If any one of the twenty lines is in the low logic state, that means the key in the array corresponding to such line at the crossover point between such line and line 152(21) is the key which has been depressed. For example, if all of twenty lines 152(1) through 152(20) remain in the high logic state except for line 152(12), that means a key has been depressed causing line 152(12) to be electrically connected to line 152(21). This must be key 166 in array 154(12), corresponding to the crossover point of lines 152(12) and 152(21).

Thus when line 152(21) is set to low with the remaining lines set to high and the remaining twenty lines remain at the high logic state, this means none of the keys corresponding to the crossover points between line 152(21) with the remaining lines is depressed.

Subsequently, line 152(20) is set to the low logic state and the remaining twenty lines are set to the high logic state, and the twenty lines are sensed to see if any of the twenty lines is at the low logic state. In such manner it is possible to detect whether the twenty keys corresponding to the crossover points between 152(20) on the one hand, and lines 152(1) through 152(19) and 152(21) on the other, have been depressed. If any of the twenty lines is at the logic low state, that means the key corresponding to the crossover point between such line and line 152(20) has been depressed. In such manner, each of the twenty-one lines is set to the low logic state with the remaining lines at the high logic state, and the remaining lines sensed to detect the depression of keys. In such manner, all of the keys in Fig. 4 can be detected as to whether they have been depressed.

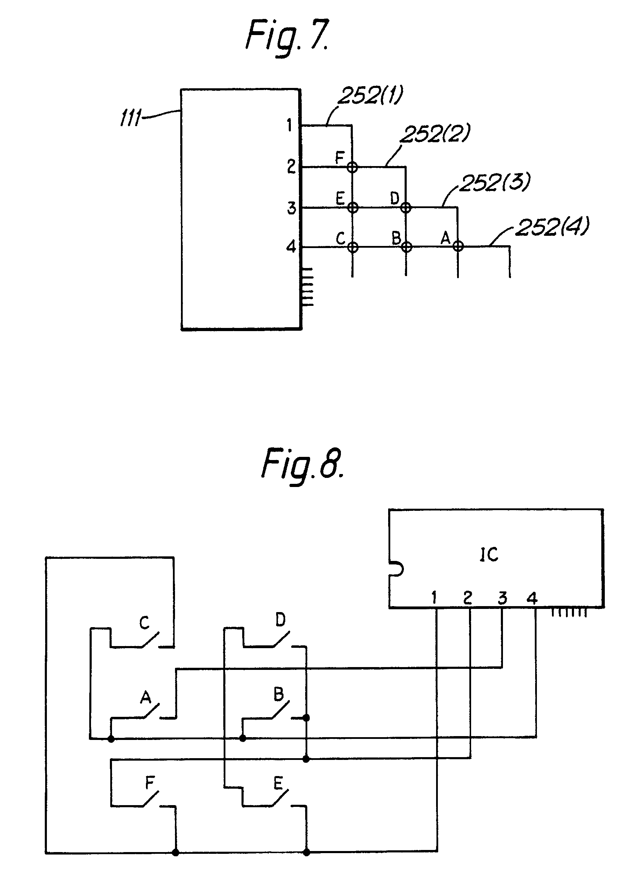

The scanning and sensing speed of the IC chip 111 is typically about 50 microseconds per line. Fig. 6 is a timing diagram illustrating the time period during which one of the twenty-one lines is scanned. As shown in Fig. 6, the line which is scanned is set to the low logic state (the remaining lines set to logic high) for a time period t, and the logic state of the remaining twenty lines must be sensed within this time interval t. Therefore, the time required for scanning sensing all twenty-one lines is 50 X 21 microseconds. This is the total time required for scanning and sensing whether any of the keys of the keyboard has been depressed. Even at the highest speed of a well-trained typist, the time during which each key is depressed is about twenty milliseconds, which is more than adequate for chip 111 to scan all twenty-one lines for detecting the depressing of the key.

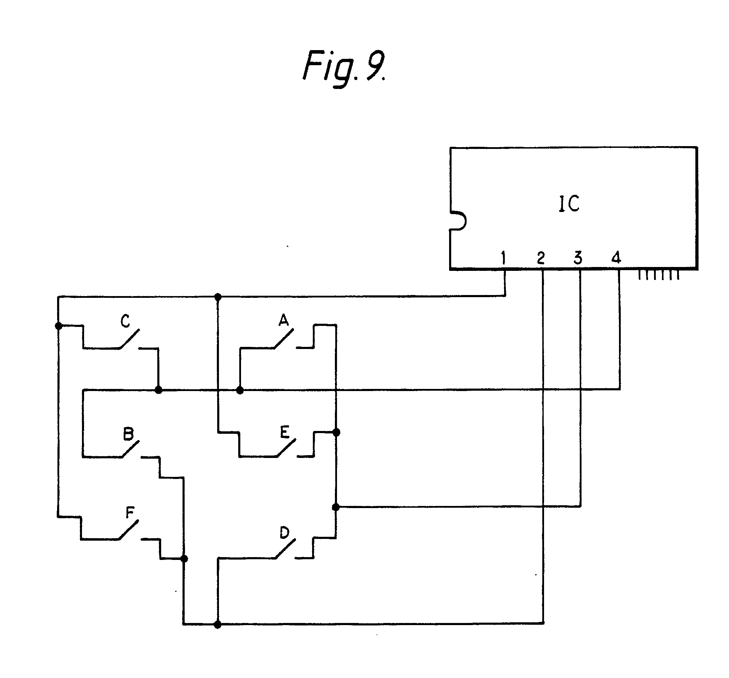

In the above description and in reference to Fig. 4, array 154 of keys forms a ladder arrangement. It will be understood, however, that this is not necessary. Since the keys in most keyboards form a rectangular arrangement, it may be desirable to arrange keys 154 in such shape instead. This is illustrated in reference to Figs. 7-9. As shown in Fig. 7, four scan and sense lines 252(1)-252(4) are shown connected to pins 1-4 of chip 111, where the remaining scan and sense lines have been omitted for simplicity. It will be evident that the arrangement of the key array A-F is in the shape of a ladder, similar to array 152 of Fig. 4. In Figs. 8 and 9, the keys A-F form a rectangular arrangement; in Figs. 8 and 9, the keys A-F are implemented as switches. It will be obvious to those skilled in the art that where keys A-F are implemented as switches, the three implementations of the encoding scircuit in Figs. 7-9 are identical.

While the above method has been described by setting the line to be scanned to the low logic state, it will be understood that scanning can also be performed by setting the line to be scanned to the high logic state and the remaining lines to the low logic state and sensing the remaining lines to see if any of such lines has risen to the high logic state. In such alternative method, the logic low states are implemented by weak pull down devices so that when a line at logic high is connected to one at logic low, the one at logic low will be pulled high. In all other respects, this alternative scanning and sensing method is the same as that described above. The order in which the lines are scanned can also be performed in ways different from that described above. Thus, the scanning can proceed from line 1 to line 21 instead of from line 21 to line 1 as described above. Furthermore, if desirable, the lines can be scanned in any predetermined order such as by scanning first odd lines and then even lines or by skipping a predetermined number of lines and later returning to the lines skipped. In other words, the scanning and sensing steps are first performed by applying a set logic state to mth line and a different logic state to the remaining lines. Then the steps are repeated for the pth line for each value of p given by $m \pm rq$, where g is an integer constant and r an integer. All such variations are within the scope of the invention.

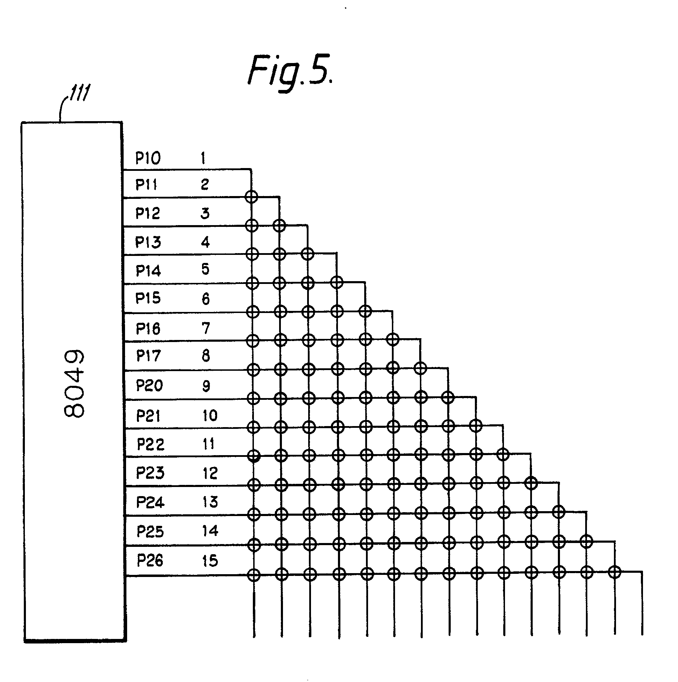

From the above, it will be evident that the purpose of the invention is achieved. With twenty-one lines and twenty-one input/output pins, a total number of two hundred and ten keys can be sensed as shown in Fig. 4. If a few number of keys need to be sensed, the number of input/output pins and the number of sscan/sensing lines may be reduced as shown in Fig. 5. As shown in Fig. 5, if only 105 keys need to be sensed, the number of input/output pins and the number of scan/sensing lines may be reduced each to fifteen instead of twenty-one as required in the conventional matrix-type encoding system described above. Since the pins of chip 111 used are input/output pins, all the lines connected to these ports may be used for both scanning and sensing. This is very different from the conventional matrix-type encoder where some of the lines are strictly used for scanning and the remaining lines used strictly for sensing and the full capability of the input/output ports of the controller chip is not fully utilized. The capability of these pins are fully utilized in the present invention since all the lines are used both for scanning and for sensing, thereby fully utilizing the capability of the input/output pins. In the conventional matrix-type encoding system, such pins are used only as input pins or only as output pins, but not both, so that the utilization is only about 50%.

## Claims

1. An encoding circuit for a keyboard, the keyboard having keys for input of information when they are depressed, the circuit comprising n lines (1-21) used for both scanning and sensing the depressing of keys, n being a positive integer, wherein the lines are arranged with respect to one another and the keys of the keyboard so that any line is electrically connectable to any of the remaining lines by depressing appropriate keys.

2. A method of operating a circuit according to claim 1, wherein the lines are arranged with respect to one another and the keys of the keyboard so that the mth line is electrically connectable to any of the remaining lines by depressing appropriate keys, wherein m is an integer smaller than or equal to n but greater than or equal to 1, the method comprising:

(a) applying a voltage to the mth line so that it is at a predetermined logic high or low state;

(b) applying voltages to the remaining lines so that they are at a logic state that it is different from that of the mth line; and

(c) sensing the logic states of the remaining lines to detect whether any of the keys has been depressed.

3. A method according to claim 2, further comprising:

(d) applying a voltage to the pth line, where p is a positive integer different from m, so that it is at a predetermined logic high or low state;

(e) applying voltages to the remaining lines so that they are at a logic state that is different from that of the pth line; and

(f) sensing the logic states of the remaining lines to detect whether any of the keys has been depressed, wherein steps (d), (e), (f) are performed after steps (a), (b), (c).

4. A method according to claim 3, wherein p is (m + 1).

5. A method according to claim 3, wherein p is (m-1).

6. A method according to any of claims 3 to 5, wherein steps (d), (e), (f) are performed for each value of p within the range of 1 to n, where p is m + rq, and where q is an integer constant and r an integer.

7. A method according to any of claims 2 to 6, wherein steps (a), (b), (c) are performed for each value of m within the range of 1 to n.

8. A method according to claim 7, wherein the steps (a), (b), (c) are performed in an ascending order from 1 to n.

9. A method according to claim 7, wherein the steps (a), (b), (c) are performed in a descending order from n to 1.

*Fig.1.*

```
               TO ⊏ 1      40 ⊐ Vcc
           XTAL 1 ⊏ 2      39 ⊐ T1
           XTAL 2 ⊏ 3      38 ⊐ P27
            RESET ⊏ 4      37 ⊐ P26
               SS ⊏ 5      36 ⊐ P25
              INT ⊏ 6      35 ⊐ P24
               EA ⊏ 7      34 ⊐ P17
               RD ⊏ 8      33 ⊐ P16
             PSEN ⊏ 9      32 ⊐ P15
               WR ⊏ 10     31 ⊐ P14
              ALE ⊏ 11     30 ⊐ P13
              DB0 ⊏ 12     29 ⊐ P12
              DB1 ⊏ 13     28 ⊐ P11
              DB2 ⊏ 14     27 ⊐ P10
              DB3 ⊏ 15     26 ⊐ VDD
              DB4 ⊏ 16     25 ⊐ PROG
              DB5 ⊏ 17     24 ⊐ P23
              DB6 ⊏ 18     23 ⊐ P22
              DB7 ⊏ 19     22 ⊐ P21
              Vss ⊏ 20     21 ⊐ P20
```
8049

*Fig.6.*

(SCAN LINE)  HIGH   LOW

(SENSE LINE)   DATA

l

*Fig.2.*

*20*

*22*

| 8049 | | |
|---|---|---|
| DB0 | 1 | |
| DB1 | 2 | |
| DB2 | 3 | |
| DB3 | 4 | |
| DB4 | 5 | |
| DB5 | 6 | |
| DB6 | 7 | |
| DB7 | 8 | |
| P20 | 9 | |
| P21 | 10 | |
| P22 | 11 | |
| P23 | 12 | |
| P24 | 13 | |
| P25 | 14 | |
| P26 | 15 | |
| P27 | 16 | |
| P10 | 17 | |
| P11 | 18 | |
| P12 | 19 | |
| P13 | 20 | |
| P14 | 21 | |

*111*

*24*

*24*

*32*

(PRIOR ART)

EP 0 427 364 A2

Fig.3. (PRIOR ART)

EP 0 427 364 A2

# Fig.4.

# Fig.5.

# Fig.7.

# Fig.8.

Fig.9.